# EUROPEAN PATENT APPLICATION

(11) **EP 4 604 209 A1**
(43) Date of publication of application: **20.08.2025**
(21) Application number: 23925699.3
(22) Date of filing: 06.03.2023
(51) Int. Cl.: H01M 4/38, H01M 4/36

(54) **SILICON-BASED NEGATIVE ELECTRODE ACTIVE MATERIAL, SECONDARY BATTERY AND ELECTRICAL DEVICE**

(71) Applicant: Contemporary Amperex Technology (Hong Kong) Limited, Hong Kong (HK)
(72) Inventor: GUO, Xiaoxin, Ningde, Fujian 352100 (CN); LV, Zijian, Ningde, Fujian 352100 (CN); WANG, Jiazheng, Ningde, Fujian 352100 (CN)
(74) Representative: Thoma, Michael
(86) International application number: PCT/CN2023/079847
(87) International publication number: WO 2024/182974

(57) **Abstract**

Provided in the present application is a silicon-based negative electrode active material. The silicon-based negative electrode active material includes silicate containing alkaline earth metal elements, and the silicon-based negative electrode active material contains both K element and P element.

## Description

### TECHNICAL FIELD

The present application relates to the technical field of batteries, and in particular, to a silicon-based negative electrode active material, a secondary battery, and an electric device.

### BACKGROUND

In recent years, as the application range of secondary batteries becomes wider, the secondary batteries are widely used in various fields such as energy storage power systems of hydraulic power stations, thermal power stations, wind power stations, and solar power stations, as well as power tools, electric bicycles, electric motorcycles, electric vehicles, military equipment, and aerospace.

Silicon-based materials are regarded as promising silicon-based negative electrode active materials for secondary batteries due to their high energy density. Due to the great development of the secondary batteries, higher requirements are put forward for their electrochemical performance and the like. Accordingly, there remains a need in the art for silicon-based negative electrode active materials with better performance.

### SUMMARY

In view of the above problems, the present application provides a novel silicon-based negative electrode active material, a secondary battery, and an electric device, which are separately described below.

In a first aspect, the present application provides a silicon-based negative electrode active material. The silicon-based negative electrode active material comprises silicate containing alkaline earth metal elements, wherein the silicon-based negative electrode active material contains both K element and P element.

In the above solution, the silicon-based negative electrode active material contains a combination of K element and P element, and the specific combination improves the cycle performance and rate performance of the silicon-based negative electrode active material. The combination of K element and P element achieves an unexpected synergistic effect, and the technical effect achieved by the combination of the two elements is significantly better than that of the simple sum of the two elements used separately. Without being limited by the following theory, K element may form a silicate structure with an oxysilicon-based material, while avoiding rapid expansion of silicon crystal grains and buffering volume expansion during cycling, thereby effectively improving cycle performance, and P element may effectively lower an ion diffusion barrier, increase a diffusion coefficient of lithium ions in a bulk phase, and contribute to improving rate performance of a battery. Therefore, the use of the silicon-based negative electrode active material of the present application enables a secondary battery to have both high cycle performance and high rate performance.

In some implementations, the content of K element is greater than the content of P element. In the above ratio range, K element and P element exhibit an unexpected synergistic effect, significantly improving the cycle performance and rate performance of the silicon-based negative electrode active material.

In some implementations, the mass ratio of K element to P element is 7:1 or more, and is optionally 9:1 to 15:1. In the above solution, the silicon-based negative electrode active material has improved cycle performance and rate performance.

In some implementations, the content of K element is 600 ppm or more, and is optionally 800 ppm to 1500 ppm. In the above solution, the silicon-based negative electrode active material has improved cycle performance and rate performance.

In some implementations, the content of P element is 500 ppm or less, and is optionally 50 ppm to 200 ppm. In the above solution, the silicon-based negative electrode active material has improved cycle performance and rate performance.

In some implementations, the silicon-based negative electrode active material has a volume average particle diameter Dᵥ50 of 4 µm to 10 µm, which is optionally 5 µm to 8 µm. In the above solution, the silicon-based negative electrode active material has improved cycle performance and rate performance.

In some implementations, the silicon-based negative electrode active material has a specific surface area of 6 m²/g or less, which is optionally 2 m²/g to 5 m²/g. In the above solution, the silicon-based negative electrode active material has improved cycle performance and rate performance.

In some implementations, the silicon-based negative electrode active material has a powder volume resistivity of 6 Ω·cm or less, which is optionally 0.5 Ω·cm to 4.5 Ω·cm, at a pressure of 4 MPa. In the above solution, the silicon-based negative electrode active material has improved cycle performance and rate performance.

In some implementations, the silicon-based negative electrode active material has a compacted density of 1.4 g/cm3³ to 1.8 g/cm3³, which is optionally 1.5 g/cm3³ to 1.7 g/cm3³, at a pressure of 49000 N. In the above solution, the silicon-based negative electrode active material has improved energy density.

In some implementations, the silicate containing alkaline earth metal elements comprises silicate containing magnesium, and the full width at half maximum of an XRD diffraction peak of the silicate containing magnesium is 0.65° or less, and is optionally 0.40° to 0.60°. In the above solution, the silicon-based negative electrode active material has improved cycle performance and rate performance.

In some implementations, the silicate containing alkaline earth metal elements comprises silicate containing magnesium, and the silicate containing magnesium has a grain size of 12 nm or more, which is optionally 13 nm to 20 nm. In the above solution, the silicon-based negative electrode active material has improved cycle performance and rate performance.

In some implementations, at least a portion of a surface of the silicon-based negative electrode active material has a coating layer.

In a second aspect, the present application provides a method for preparing the silicon-based negative electrode active material according to any one of the above implementations, comprising:
providing raw materials containing Si element, O element, K element, P element, and alkaline earth metal element;
using a vapor deposition method to heat the raw materials to form vapor and then cool the vapor to form a deposit;
pulverizing the deposit to obtain a pulverized product.

In some implementations, the method for preparing the silicon-based negative electrode active material further comprises:
performing coating treatment on the pulverized product to obtain a product having a coating layer.

In some implementations, in the operation of heating the raw materials to form vapor, the heating temperature is 1100°C to 1550°C.

In some implementations, in the operation of cooling the vapor to form a deposit, the cooling temperature is 700°C to 900°C.

In a third aspect, the present application provides a secondary battery comprising a negative electrode. The negative electrode comprises the silicon-based negative electrode active materials according to any one of the above implementations.

In a fourth aspect, the present application provides an electric device, comprising the secondary battery according to any one of the above implementations.

### BENEFICIAL EFFECTS

One or a plurality of implementations of the present application have one or a plurality of the following beneficial effects:
(1) K element and P element achieve an unexpected synergistic effect, and the technical effect achieved by the combination of the two elements is significantly better than that of the simple sum of the two elements used separately.
(2) The silicon-based negative electrode active material has improved cycle performance.
(3) The silicon-based negative electrode active material has improved rate performance.
(4) The silicon-based negative electrode active material has higher energy density.

### BRIEF DESCRIPTION OF DRAWINGS

FIG. 1 is a schematic diagram of a secondary battery according to an implementation of the present application;
FIG. 2 is an exploded view of the secondary battery according to the implementation of the present application shown in FIG. 1;
FIG. 3 is a schematic diagram of a battery module according to an implementation of the present application;
FIG. 4 is a schematic diagram of a battery pack according to an implementation of the present application;
FIG. 5 is an exploded view of the battery pack according to the implementation of the present application shown in FIG. 4; and
FIG. 6 is a schematic diagram of an electric device using a secondary battery as a power source according to an implementation of the present application.

Description of Reference Numerals
1-Battery pack; 2-Upper case; 3-Lower case; 4-Battery module; 5-Secondary battery; 51-Housing; 52-Electrode assembly; 53-Cap assembly.

### DESCRIPTION OF EMBODIMENTS

Hereinafter, implementations specifically disclosing a silicon-based negative electrode active material, a method for preparing the same, a positive electrode tab, a negative electrode tab, a secondary battery, a battery module, a battery pack, and a device of the present application will be described in detail with reference to the accompanying drawings as appropriate. However, unnecessary detailed description may be omitted. For example, detailed description of well-known matters and redundant description of substantially the same configuration may be omitted. This is to avoid the following description from becoming unnecessarily redundant and to facilitate understanding by those skilled in the art. The accompanying drawings and the following description are provided for a person skilled in the art to fully understand the present application, and are not intended to limit the subject matter described in the claims.

"Range" disclosed herein is defined in terms of a lower limit and an upper limit, with a given range being defined by a selection of one lower limit and one upper limit, the selection of the lower limit and the upper limit defining the boundaries of a particular range. The range defined in this way may be either inclusive or exclusive and may be arbitrarily combined, i.e., any lower limit may be combined with any upper limit to form a range. For example, if ranges of 60 to 120 and 80 to 110 are listed for a particular parameter, it is understood that ranges of 60 to 110 and 80 to 120 are also contemplated. Further, if the smallest range values of 1 and 2 are listed, and if the largest range values of 3, 4 and 5 are listed, the following ranges are all contemplated: 1 to 3, 1 to 4, 1 to 5, 2 to 3, 2 to 4, and 2 to 5. In the present application, unless otherwise stated, the numerical range "a-b" represents a shorthand notation for any combination of a and b, where a and b are both real numbers. For example, a numerical range of "0 to 5" means that all real numbers between "0 to 5" have been fully set forth herein, and "0 to 5" is merely a shorthand representation of such numerical combinations. Further, when a parameter is expressed as an integer ≧ 2, the parameter is, for example, an integer of 2, 3, 4, 5, 6, 7, 8, 9, 10, 11, 12, or the like.

Unless otherwise specified, all implementations and alternative implementations of the present application may be combined with each other to form new technical solutions.

Unless otherwise specified, all the steps of the present application may be performed sequentially or randomly, preferably sequentially. For example, the method includes steps (a) and (b), meaning that the method may include steps (a) and (b) performed sequentially or may include steps (b) and (a) performed sequentially. For example, the method may further include step (c), meaning that step (c) may be added to the method in any order, e.g. the method may include steps (a), (b) and (c), may also include steps (a), (c) and (b), may also include steps (c), (a) and (b), etc.

Unless otherwise specified, the terms "including" and "containing" as used herein are meant to be open or closed. For example, the "including" and "containing" may mean that other components not listed may be further included or contained, or only the listed components may be included or contained.

In this application, the term "or" is inclusive, unless specifically stated otherwise. For example, the phrase "A or B" means "A, B, or both A and B". More specifically, the condition "A or B" is satisfied by either A being true (or present) and B being false (or absent), A being false (or absent) and B being true (or present), or both A and B being true (or present).

In this context, ppm is parts per million. However, when ppm is used to describe the content of K element or P element, it means parts per million by mass of K element or P element in a silicon-based negative electrode active material.

### [Secondary Battery]

A secondary battery, also known as a rechargeable battery or a storage battery, refers to a battery that can continue to be used by activating an active material by means of charging after discharging the battery.

In general, a secondary battery includes a positive electrode tab, a negative electrode tab, a separator, and an electrolyte. During charge and discharge of the battery, active ions (e.g., sodium ions) are intercalated and deintercalated back and forth between the positive electrode tab and the negative electrode tab. The separator is provided between the positive electrode tab and the negative electrode tab to mainly prevent the positive and negative electrodes from being short-circuited and allow active ions to pass therethrough. The electrolyte mainly functions to conduct active ions between the positive electrode tab and the negative electrode tab.

The secondary battery is, for example, a lithium-ion battery. The lithium-ion battery mainly includes a positive electrode, a negative electrode, a separator, and an electrolyte. The positive and negative electrodes are separated by a separator to prevent short circuit, and the electrolyte wets the positive and negative electrodes to ensure ionic conduction. During charging, Li⁺ is deintercalated from the positive electrode and intercalated into the negative electrode through the separator via the electrolyte, so that the positive electrode is in a sodium-poor state at a high potential and the negative electrode is in a sodium-rich state at a low potential. On the contrary, in a discharge process, Li+ is deintercalated from the negative electrode and intercalated into a positive electrode material through the separator via the electrolyte, restoring the positive electrode to a sodium-rich state. In order to maintain the charge balance, the same number of electrons are transferred through an external circuit during charge and discharge, and migrate between the positive and negative electrodes together with Li+, so that oxidation and reduction reactions occur in the positive and negative electrodes, respectively. Lithium ions can reversibly migrate between the positive electrode and the negative electrode in the electrolyte, and each of the positive electrode and the negative electrode is composed of an insertion-type material that allows lithium ions to be reversibly inserted and deintercalated.

The secondary battery is, for example, a sodium-ion battery. The sodium-ion battery mainly includes a positive electrode, a negative electrode, a separator, and an electrolyte. The positive and negative electrodes are separated by a separator to prevent short circuit, and the electrolyte wets the positive and negative electrodes to ensure ionic conduction. During charging, Na⁺ is deintercalated from the positive electrode and intercalated into the negative electrode through the separator via the electrolyte, so that the positive electrode is in a sodium-poor state at a high potential and the negative electrode is in a sodium-rich state at a low potential. On the contrary, in a discharge process, Na+ is deintercalated from the negative electrode and intercalated into a positive electrode material through the separator via the electrolyte, restoring the positive electrode to a sodium-rich state. In order to maintain the charge balance, the same number of electrons are transferred through an external circuit during charge and discharge, and migrate between the positive and negative electrodes together with Na+, so that oxidation and reduction reactions occur in the positive and negative electrodes, respectively. Sodium ions can reversibly migrate between the positive electrode and the negative electrode in the electrolyte, and each of the positive electrode and the negative electrode is composed of an insertion-type material that allows sodium ions to be reversibly inserted and deintercalated.

### [Negative Electrode Tab]

The negative electrode tab includes a negative electrode current collector and a negative electrode film layer disposed on at least one surface of the negative electrode current collector, the negative electrode film layer including a negative electrode active material.

The negative electrode active material of the present application is a silicon-based negative electrode active material including silicate containing alkaline earth metal elements, and the silicon-based negative electrode active material contains both K element and P element.

In the above solution, the silicon-based negative electrode active material contains a combination of K element and P element, and the specific combination improves the cycle performance and rate performance of the silicon-based negative electrode active material. The combination of K element and P element achieves an unexpected synergistic effect, and the technical effect achieved by the combination of the two elements is significantly better than that of the simple sum of the two elements used separately. Without being limited by the following theory, K element may form a silicate structure with an oxysilicon-based material, which effectively reduces consumption of lithium ions, thereby effectively improving cycle performance, and P element may effectively reduce an ion diffusion barrier, increase a diffusion coefficient of lithium ions in a bulk phase, and contribute to improving rate performance of a battery. Therefore, the use of the silicon-based negative electrode active material of the present application enables a secondary battery to have both high cycle performance and high rate performance.

In some implementations, the silicon in the silicon-based negative electrode active material may be present in a plurality of silicon phases including crystalline silicon. Specifically, the silicon phase may be uniformly distributed and intercalated/buried in a matrix including the silicon-based negative electrode active material. In other words, the silicon phase may be dispersed and uniformly distributed in the matrix.

In some implementations, the alkaline earth metal element includes one or a plurality of Mg element, Be element, Ca element, or Ba element. In the above implementations, the silicon-based negative electrode active materials all exhibit improved cycle performance and rate performance.

In some implementations, the alkaline earth metal element includes Mg element. In the above implementations, the silicon-based negative electrode active materials all exhibit further improved cycle performance and rate performance.

In some implementations, the silicate containing alkaline earth metal elements includes silicate containing magnesium, and the full width at half maximum of an XRD diffraction peak of the silicate containing magnesium is 0.65° or less, and is optionally 0.40° to 0.60°. In the above solution, the silicon-based negative electrode active material has further improved cycle performance and rate performance.

In some implementations, the silicate containing alkaline earth metal elements includes silicate containing magnesium, and the silicate containing magnesium has a grain size of 12 nm or more, which is optionally 13 nm to 20 nm. In the above solution, the silicon-based negative electrode active material has further improved cycle performance and rate performance.

In some implementations, the silicon-based negative electrode active material contains at least one of silicon grains and silicon oxide material grains.

In some implementations, K element and P element are grown in the silicon-based negative electrode active material, e.g., during vapor deposition of the silicon-based negative electrode active material. In some implementations, K element and P element are grown in the silicon-based negative electrode active material upon co-vapor deposition with the silicon-based negative electrode active material.

In some implementations, the content of K element in the silicon-based negative electrode active material is greater than the content of P element. In the above ratio range, K element and P element exhibit an unexpected synergistic effect, further significantly improving the cycle performance and rate performance of the silicon-based negative electrode active material.

In some implementations, the silicon-based negative electrode active material has a mass ratio of K to P of 7:1 or more (e.g., 7.7:1). In the above ratio range, K element and P element exhibit an unexpected synergistic effect, further significantly improving the cycle performance and rate performance of the negative electrode active material.

In some implementations, the silicon-based negative electrode active material has a mass ratio of K to P of 7:1 to 15:1 (e.g., 7.7:1 to 14.1:1). In the above ratio range, K element and P element exhibit an unexpected synergistic effect, further significantly improving the cycle performance and rate performance of the negative electrode active material.

In some implementations, the silicon-based negative electrode active material has a mass ratio of K to P of 10:1 to 14:1 (e.g., 10.3:1 to 13.8:1). In the above ratio range, K element and P element exhibit an unexpected synergistic effect, further significantly improving the cycle performance and rate performance of the negative electrode active material.

In some implementations, the silicon-based negative electrode active material has a mass ratio of K to P of 12:1 to 13:1. In the above ratio range, K element and P element exhibit an unexpected synergistic effect, further significantly improving the cycle performance and rate performance of the negative electrode active material.

In some implementations, the mass ratio of K element to P element in the silicon-based negative electrode active material may be 20:1 or less, 15:1 or less, 14:1 or less, 13:1 or less, 12:1 or less. In some implementations, the mass ratio of K element to P element in the silicon-based negative electrode active material may be 2:1 or more, 3:1 or more, 4:1 or more, 5:1 or more, 6:1 or more, 7:1 or more, 8:1 or more. The mass ratio of K element to P element may be composed of any of the upper and lower limit values described above. In the above ratio range, K element and P element exhibit an unexpected synergistic effect, further significantly improving the cycle performance and rate performance of the negative electrode active material.

In some implementations, the mass ratio of K element to P element may be 13-14:1, optionally 12-14:1, optionally 11-14:1, optionally 10-14:1, optionally 9-14:1, optionally 9-15:1, optionally 8-15:1, optionally 7-15:1, optionally 6-15:1, optionally 5-15:1, optionally 4-15:1, optionally 3-15:1, optionally 2-15:1, optionally 1-15:1.

In some implementations, the content of K element in the silicon-based negative electrode active material is 600 ppm or more. In the above content range, K element and P element exhibit an unexpected synergistic effect, significantly improving the cycle performance and rate performance of the silicon-based negative electrode active material.

In some implementations, the content of K element in the silicon-based negative electrode active material is 800 ppm to 1500 ppm. Based on this, the negative electrode active material has further improved cycle performance and rate performance. In the above content range, K element and P element exhibit an unexpected synergistic effect, further significantly improving the cycle performance and rate performance of the silicon-based negative electrode active material.

In some implementations, the content of K element in the silicon-based negative electrode active material is 1000 ppm to 1500 ppm. Based on this, the negative electrode active material has further improved cycle performance and rate performance. In the above content range, K element and P element exhibit an unexpected synergistic effect, further significantly improving the cycle performance and rate performance of the silicon-based negative electrode active material.

In some implementations, the content of K element in the silicon-based negative electrode active material is 1100 ppm to 1400 ppm. Based on this, the negative electrode active material has further improved cycle performance and rate performance. In the above content range, K element and P element exhibit an unexpected synergistic effect, further significantly improving the cycle performance and rate performance of the silicon-based negative electrode active material.

In some implementations, the content of K element in the silicon-based negative electrode active material is 1100 ppm to 1300 ppm. Based on this, the negative electrode active material has further improved cycle performance and rate performance. In the above content range, K element and P element exhibit an unexpected synergistic effect, further significantly improving the cycle performance and rate performance of the silicon-based negative electrode active material.

In some implementations, the content of K element in the silicon-based negative electrode active material is a K content of 1200 ppm to 1300 ppm. Based on this, the negative electrode active material has further improved cycle performance and rate performance. In the above content range, K element and P element exhibit an unexpected synergistic effect, significantly improving the cycle performance and rate performance of the silicon-based negative electrode active material.

In some implementations, the upper limit value of the content of K element in the silicon-based negative electrode active material may be selected from any one of 1500 ppm, 1400 ppm, 1300 ppm, and 1200 ppm, and the lower limit value of the content of K element may be selected from any one of 600 ppm, 700 ppm, 800 ppm, 900 ppm, 1000 ppm, and 1100 ppm. That is, the range of the content of K element may be composed of any of the upper and lower limit values described above. In the above content range, K element and P element exhibit an unexpected synergistic effect, significantly improving the cycle performance and rate performance of the silicon-based negative electrode active material.

In some implementations, the content of K element in the silicon-based negative electrode active material is 1200 ppm to 1300 ppm, optionally 1100 ppm to 1300 ppm, optionally 1200 ppm to 1400 ppm, optionally 1100 ppm to 1400 ppm, optionally 1000 ppm to 1400 ppm, optionally 1000 ppm to 1500 ppm, and optionally 800 ppm to 1500 ppm.

In some implementations, the content of P element in the silicon-based negative electrode active material is 500 ppm or less. Based on this, the negative electrode active material has further improved cycle performance and rate performance.

In some implementations, the content of P element in the silicon-based negative electrode active material is 50 ppm to 200 ppm. Based on this, the negative electrode active material has further improved cycle performance and rate performance.

In some implementations, the content of P element in the silicon-based negative electrode active material is 75 ppm to 150 ppm. Based on this, the negative electrode active material has further improved cycle performance and rate performance.

In some implementations, the content of P element in the silicon-based negative electrode active material is 75 ppm to 100 ppm. Based on this, the negative electrode active material has further improved cycle performance and rate performance.

In some implementations, the content of P element in the silicon-based negative electrode active material is 80 ppm to 95 ppm. Based on this, the negative electrode active material has further improved cycle performance and rate performance.

In some implementations, the upper limit value of the content of P element in the silicon-based negative electrode active material may be selected from any one of 200 ppm, 190 ppm, 170 ppm, 150 ppm, and 130 ppm, and the lower limit value of the content of P element may be selected from any one of 30 ppm, 40 ppm, 50 ppm, 60 ppm, 70 ppm, 80 ppm, 90 ppm, and 100 ppm, that is, the range of the content of P element may be composed of any of the upper and lower limit values described above. In the above content range, K element and P element exhibit an unexpected synergistic effect, significantly improving the cycle performance and rate performance of the silicon-based negative electrode active material.

In some implementations, the content of P element in the silicon-based negative electrode active material is 90 ppm to 100 ppm, optionally 80 ppm to 100 ppm, optionally 80 ppm to 110 ppm, optionally 80 ppm to 120 ppm, optionally 70 ppm to 120 ppm, optionally 70 ppm to 130 ppm, optionally 70 ppm to 140 ppm, optionally 70 ppm to 150 ppm, optionally 70 ppm to 160 ppm, optionally 70 ppm to 170 ppm, optionally 70 ppm to 180 ppm, optionally 70 ppm to 180 ppm, optionally 70 ppm to 190 ppm, optionally 70 ppm to 200 ppm, optionally 60 ppm to 200 ppm, optionally 50 ppm to 200 ppm.

In some implementations, the silicon-based negative electrode active material has a volume average particle diameter Dᵥ50 of 4 µm to 10 µm, which is optionally 5 µm to 8 µm. In the above solution, the silicon-based negative electrode active material has improved cycle performance and rate performance.

In some implementations, the volume average particle diameter Dᵥ50 of the silicon-based negative electrode active material may be selected to be 4 µm or more, more optionally 5 µm or more, which can reduce the consumption of active ions in the negative electrode to form a film and reduce the side reaction of the electrolyte in the negative electrode, thereby reducing the irreversible capacity of the secondary battery and improving the cycle performance of the secondary battery. In addition, this can further reduce the amount of a binder added in the negative electrode tab, which is advantageous in increasing the energy density of the secondary battery. The average particle diameter Dᵥ50 is optionally 10 µm or less, more optionally 8 µm or less, so that the migration path of active ions and electrons in material particles is short, the migration rate of ions and electrons is increased, thereby improving the kinetic performance of the secondary battery, and the silicon-based negative electrode active material is prevented from being broken during charge and discharge, thereby improving the cycle performance of the secondary battery.

In some implementations, the silicon-based negative electrode active material has a specific surface area of 6 m²/g or less, which is optionally 2 m²/g to 5 m²/g. In the above solution, the silicon-based negative electrode active material has further improved cycle performance and rate performance.

In some implementations, the silicon-based negative electrode active material has a specific surface area of 2 m²/g to 6 m²/g. The specific surface area is optionally 2 m²/g or more, so that the surfaces of the material particles have more active sites, the electrochemical properties of the silicon-based negative electrode active material can be effectively improved, and the kinetic performance requirement of the secondary battery can be satisfied. The specific surface area may be selected to be 6 m²/g or less, which is advantageous in reducing the side reaction of the electrolyte in the negative electrode, and can also reduce the consumption of the active ions in the negative electrode to form a film, thereby reducing the irreversible capacity of the secondary battery and improving the cycle performance of the secondary battery.

In some implementations, the silicon-based negative electrode active material has a powder volume resistivity of 6 Ω·cm or less, which is optionally 0.5 Ω·cm to 4.5 Ω·cm, at a pressure of 4 MPa. In the above solution, the silicon-based negative electrode active material has further improved rate performance.

In some implementations, the silicon-based negative electrode active material has a powder volume resistivity of 6 Ω·cm or less, which is optionally 4.5 Ω·cm or less, at a pressure of 4 MPa. When the powder volume resistivity of the silicon-based negative electrode active material is within the above range, it is possible to reduce the inhibition of the migration of electrons inside the particles, and it is advantageous improving the kinetic performance of the silicon-based negative electrode active material.

In some implementations, the silicon-based negative electrode active material has a compacted density of 1.4 g/cm³ to 1.8 g/cm³, which is optionally 1.5 g/cm³ to 1.7 g/cm³, at a pressure of 49000 N. In the above solution, the battery has further improved energy density.

In some implementations, the silicon-based negative electrode material contains a Si element and an O element, the molar ratio of O element to Si element being greater than 0 and less than 2, optionally 0.2 to 1.8:1, further optionally 0.3 to 1.7:1, further optionally 0.4 to 1.6:1, further optionally 0.6 to 1.5:1, further optionally 0.7 to 1.4:1, further optionally 0.8 to 1.3:1, further optionally 0.9 to 1.2:1, further optionally 1.0 to 1.1:1.

In some implementations, at least a portion of a surface of the silicon-based negative electrode active material has a coating layer.

In some implementations, the material of the coating layer includes one or a plurality of a polymer, a carbon material, a metal material, or a metal compound. For example, the coating layer includes one or a plurality of a polymer coating layer, a carbon coating layer, or a metal compound coating layer. Optionally, the polymer may be selected from one or a plurality of polyaniline, polyacetylene, polystyrene, polyacrylonitrile, polyvinyl chloride, or polyethylene. Optionally, the carbon material may include one or a plurality of graphite, mesocarbon microbeads (MCMB), hydrocarbon pyrolytic carbon, hard carbon, or soft carbon, where the graphite may be one or a plurality of natural graphite or artificial graphite. Alternatively, the metal compound may include one or a plurality of Ti₅Si₃, Al₂O₃, or TiO₂. The coating layer can further alleviate the volume expansion effect of the silicon-based negative electrode active material, increasing the cycle life of the material. In addition, the coating layer further protects the silicon-based negative electrode active material, suppresses the side reaction of the electrolyte on the surface of the material, and protects the surface of the material from corrosion by the electrolyte, so that the silicon-based negative electrode active material has a higher capacity, and the cycle life of the battery is further increased.

In a second aspect, the present application provides a method for preparing the silicon-based negative electrode active material according to any one of the above implementations, including:
providing raw materials containing Si element, O element, K element, P element, and alkaline earth metal element;
using a vapor deposition method to heat the raw materials to form vapor and then cool the vapor to form a deposit;
pulverizing the deposit to obtain a pulverized product.

In some implementations, the method for preparing the silicon-based negative electrode active material further includes:
performing coating treatment on the pulverized product to obtain a product having a coating layer.

In some implementations, Si element in the raw material may be derived from elemental silicon and silicon oxide, and O element in the raw material may be derived from silicon oxide. The elemental silicon includes, for example, metallic silicon. The silicon oxide includes, for example, one or a plurality of silicon monoxide (SiO) or silicon dioxide (SiO₂). The purity of the elemental silicon is, for example, 3N or more, 4N or more, 5N or more, or 6N or more.

In some implementations, K element in the raw material may be derived from elemental silicon or K element contained in the silicon oxide itself, or from a potassium source added to the raw material.

In some implementations, P element in the raw material may be derived from elemental silicon or P element contained in the silicon oxide itself, or from a phosphorus source added to the raw material.

In some implementations, the alkaline earth metal element in the raw material may be derived from elemental silicon or alkaline earth metal element inherently contained in silicon oxide, or may be derived from an alkaline earth metal source added to the raw material.

In some implementations, the potassium source may be selected from one or a plurality of potassium oxide, potassium hydroxide, potassium chloride, or potassium silicate.

In some implementations, the phosphorus source may be selected from one or a plurality of elemental phosphorus, phosphorus oxide, or phosphate.

In some implementations, the alkaline earth metal source may be selected from one or a plurality of elemental alkaline earth metal, an alkaline earth metal alloy, or an alkaline earth metal compound, where the alkaline earth metal compound may be selected from one or a plurality of alkaline earth metal oxide, alkaline earth metal sulfide, alkaline earth metal carbonate, alkaline earth metal hydroxide, alkaline earth metal acetate, alkaline earth metal oxalate, alkaline earth metal nitrate, or alkaline earth metal sulfate.

In some implementations, the raw materials containing Si element, O element, K element, P element, and alkaline earth metal element include elemental silicon, silicon dioxide, a potassium source, a phosphorus source, and an alkaline earth metal source.

In some implementations, the content of K element in the negative electrode active material is adjusted by adjusting the kind and addition amount of the potassium source in the raw material.

In some implementations, the content of P element in the negative electrode active material is adjusted by one or a plurality of means of mixing silicon oxide powders or metal silicon powders having a plurality of P contents and adjusting the kind and addition amount of the phosphorus source.

In some implementations, heating the raw material to form a vapor is carried out in an inert atmosphere at normal pressure or reduced pressure.

In some implementations, cooling the vapor to form a deposit is carried out in an inert atmosphere at normal pressure or reduced pressure.

In the above-described preparation method, the inert atmosphere may be a nitrogen atmosphere, an argon atmosphere, a helium atmosphere, or the like. Alternatively, the absolute pressure of the inert atmosphere is normal pressure (1 standard atmospheric pressure) or reduced pressure (less than 1 standard atmospheric pressure). Optionally, the absolute pressure of the inert atmosphere is between 10 Pa and 950 Pa, more optionally between 20 Pa and 100 Pa.

In some implementations, the contents of K element and P element in the finally obtained silicon-based negative electrode active material can be correspondingly increased by decreasing the pressure (i.e., increasing the degree of vacuum) within the above-described range of the inert atmosphere pressure.

In some implementations, in the operation of heating the raw materials to form vapor, the heating temperature is 1100°C to 1550°C.

In some implementations, in the operation of cooling the vapor to form a deposit, the cooling temperature is 700°C to 900°C.

In some implementations, in the operation of cooling the vapor to form the deposit, the temperature of the cooling may be adjusted to obtain the proper crystal structure of the deposit. Optionally, the cooling temperature is 850°C to 1050°C, which is advantageous in obtaining a better crystallite size and a suitable crystallinity of the silicon-based negative electrode active material, so that the silicon-based negative electrode active material has higher cycle performance and cycle performance. When the cooling temperature is lower than 800°C, the crystallinity of the material may be too low, which affects the cycle performance of the material, and when the cooling temperature is higher than 1050°C, the crystallite size of the material may be too large, which affects the cycle performance of the material.

In some implementations, within the above heating temperature range, increasing the temperature enables the contents of K element and P element in the finally obtained silicon-based negative electrode active material to be correspondingly increased.

In some implementations, within the above range of the pressure of the inert atmosphere, decreasing the pressure, i.e., increasing the degree of vacuum, enables the contents of K element and P element in the finally obtained silicon-based negative electrode active material to be correspondingly increased.

In some implementations, the operation of pulverizing the deposit includes a coarse-fine-classifying operation of the deposit according to predetermined volume average particle diameter (Dv50) and specific surface area parameters of the product, resulting in a product meeting the predetermined parameters. In some implementations, the deposit may be crushed and classified using any method and equipment known in the art, such as a mill or an integrated air flow crushing and classifying machine.

In some implementations, the method for preparing the silicon-based negative electrode active material further includes an operation of performing coating treatment on the pulverized product to obtain a product having a coating layer.

In some implementations, the material of the coating layer includes one or a plurality of a polymer, a carbon material, a metal material, or a metal compound. For example, the coating layer includes one or a plurality of a polymer coating layer, a carbon coating layer, or a metal compound coating layer. Optionally, the polymer may be selected from one or a plurality of polyaniline, polyacetylene, polystyrene, polyacrylonitrile, polyvinyl chloride, or polyethylene. Optionally, the carbon material may include one or a plurality of graphite, mesocarbon microbeads (MCMB), hydrocarbon pyrolytic carbon, hard carbon, or soft carbon, where the graphite may be one or a plurality of natural graphite or artificial graphite. Alternatively, the metal compound may include one or a plurality of Ti₅Si₃, Al₂O₃, or TiO₂. The coating layer can further alleviate the volume expansion effect of the silicon-based negative electrode active material, increasing the cycle life of the material. In addition, the coating layer further protects the silicon-based negative electrode active material, suppresses the side reaction of the electrolyte on the surface of the material, and protects the surface of the material from corrosion by the electrolyte, so that the silicon-based negative electrode active material has a higher capacity, and the cycle life of the battery is further increased.

In some implementations, a coating process is performed on the surface of the silicon-based negative electrode active material using a liquid phase coating method to form a coating layer. For example, the polymer is dissolved in a specific solvent, sufficiently stirred and uniformly mixed with the silicon-based negative electrode active material particles, and then the solvent is removed by evaporation, so that the polymer is uniformly coated on the surface of the silicon-based negative electrode active material particles.

In some implementations, the surface of the silicon-based negative electrode active material is coated with a chemical vapor deposition process to form a coating layer. For example, a gas of a hydrocarbon compound is introduced into a reaction furnace containing a silicon-based negative electrode active material, and heat treatment is performed in an inert atmosphere to carbonize the hydrocarbon compound to form a coating layer coating the surface of the silicon-based negative electrode active material, thereby obtaining a silicon-based negative electrode active material having a coating layer coated on the surface thereof.

In some implementations, the coating treatment includes carbon coating treatment. Optionally, the carbon coating treatment includes an operation of placing the pulverized product in a chamber containing a carbon source gas, heating it to 700°C to 1000°C, and keeping at this temperature for 1 h to 6 h.

In some implementations, the coating treatment includes carbon coating treatment. Optionally, the carbon coating treatment includes an operation of placing the pulverized product in a chamber containing a carbon source gas, heating it to 800°C to 900°C, and keeping at this temperature for 2 h to 5 h.

In some implementations, the alkaline earth metal source may be one or a plurality of elemental alkaline earth metal, alkaline earth metal hydroxide, alkaline earth metal carbonate, alkaline earth metal nitrate, alkaline earth metal amide, or alkaline earth metal hydride.

In some implementations, the alkaline earth metal source may be one or a plurality of metallic magnesium, magnesium hydroxide, magnesium carbonate, magnesium nitrate, magnesium amide, or magnesium hydride.

As an example, the negative electrode current collector has two surfaces opposed in its own thickness direction, and the negative electrode film layer is provided on either one or both of the two opposed surfaces of the negative electrode current collector.

In some implementations, the negative current collector may employ a metal foil or composite current collector. For example, a copper foil may be used as the metal foil. The composite current collector may include a polymeric material base layer and a metal layer formed on at least one surface of the polymeric material substrate. The composite current collector may be formed by forming a metal material (copper, a copper alloy, nickel, a nickel alloy, titanium, a titanium alloy, silver, a silver alloy, and the like) on a base material of a polymer material such as a base material of polypropylene (PP), polyethylene terephthalate (PET), polybutylene terephthalate (PBT), polystyrene (PS), polyethylene (PE), and the like.

In some implementations, the negative electrode film layer may further include a silicon-based negative electrode active material known in the art other than the present application, which may be selected by a person skilled in the art according to actual requirements. Examples may include, but are not limited to, one or a plurality of artificial graphite, natural graphite, hard carbon, soft carbon, other silicon-based materials, or tin-based materials. The other silicon-based material may include one or a plurality of elemental silicon, a silicon-oxygen composite different from the present application, a silicon-carbon composite, a silicon-nitrogen composite, or a silicon alloy. The tin-based material may include one or a plurality of elemental tin, a tin oxide compound, or a tin alloy. These materials are all commercially available.

In some implementations, the negative electrode film layer optionally further includes a binder. As an example, the binder may be selected from at least one of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethylchitosan (CMCS).

In some implementations, the negative electrode film layer further optionally includes a conductive agent. As an example, the conductive agent may be selected from at least one of superconducting carbon, acetylene black, carbon black, ketjen black, carbon dot, carbon nanotube, graphene, and carbon nanofiber.

In some implementations, the negative film layer may also optionally include other adjuvants, such as thickening agents (e.g., sodium carboxymethylcellulose (CMC-Na)), and the like.

In some implementations, the negative electrode tab may be prepared by dispersing the above-mentioned components for preparing the negative electrode tab, for example, the silicon-based negative electrode active material, the conductive agent, the binder, and any other components in a solvent (for example, deionized water) to form a negative electrode slurry, and the negative electrode slurry may be coated on a negative electrode current collector, followed by drying, cold pressing, and the like.

### [Positive Electrode Tab]

In some implementations, the positive electrode tab generally includes a positive electrode current collector and a positive electrode film layer disposed on at least one surface of the positive electrode current collector, the positive electrode film layer including a positive electrode active material.

As an example, the positive electrode current collector has two surfaces opposed in its own thickness direction, and the positive electrode film layer is provided on either one or both of the two opposed surfaces of the positive electrode current collector.

In some implementations, the positive electrode current collector may employ a metal foil or composite current collector. For example, an aluminum foil can be used as the metal foil. The composite current collector may include a polymer material base layer and a metal layer formed on at least one surface of the polymer material base layer. The composite current collector may be formed by forming a metal material (aluminum, an aluminum alloy, nickel, a nickel alloy, titanium, a titanium alloy, silver, a silver alloy, and the like) on a base material of a polymer material such as a base material of polypropylene (PP), polyethylene terephthalate (PET), polybutylene terephthalate (PBT), polystyrene (PS), polyethylene (PE), and the like.

In some implementations, the positive electrode film layer optionally further includes a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

In some implementations, the positive electrode film layer further optionally includes a conductive agent. As an example, the conductive agent may include at least one of superconducting carbon, acetylene black, carbon black, ketjen black, carbon dots, carbon nanotubes, graphene, and carbon nanofibers.

In some implementations, the positive electrode tab may be prepared by dispersing the above components for preparing a positive electrode tab, for example, a positive electrode active material, a conductive agent, a binder, and any other components in a solvent (for example, N-methylpyrrolidone) to form a positive electrode slurry, and applying the positive electrode slurry to a positive electrode current collector, followed by drying, cold pressing, and the like.

### [Positive Electrode Active Material]

In some implementations, the positive electrode active material may employ a positive electrode active material for a secondary battery, which is known in the art.

As an example, the positive electrode active material may include at least one of olivine-structured lithium-containing phosphate, lithium-transition metal oxide, and their respective modifying compounds. However, the present application is not limited to these materials, and other conventional materials that can be used as a positive electrode active material of a battery may also be used. These positive electrode active materials may be used alone or in combination of two or more thereof. Among them, examples of the lithium transition metal oxide may include, but are not limited to, at least one of lithium cobalt oxide (e.g., LiCoO₂), lithium nickel oxide (e.g., LiNiO₂), lithium manganese oxide (e.g., LiMnO₂ or LiMn₂O₄), lithium nickel cobalt oxide, lithium manganese cobalt oxide, lithium nickel manganese oxide, lithium nickel cobalt manganese oxide (e.g., LiNi_{1/3}Co_{1/3}Mn_{1/3}O₂ (also simply referred to as NCM₃₃₃), LiNi_{0.5}Co_{0.2}Mn_{0.3}O₂ (also simply referred to as NCM₅₂₃), LiNi_{0.5}Co_{0.25}Mn_{0.25}O₂ (also simply referred to as NCM₂₁₁), LiNi_{0.6}Co_{0.2}Mn_{0.2}O₂ (also simply referred to as NCM₆₂₂), LiNi_{0.8}Co_{0.1}Mn_{0.1}O₂ (also simply referred to as NCM₈₁₁)), lithium nickel cobalt aluminum oxide (e.g., LiNi_{0.85}Co_{0.15}Al_{0.05}O₂), modifying compounds thereof, and the like. Examples of the olivine-structured lithium-containing phosphate may include, but are not limited to, at least one of lithium iron phosphate (e.g., LiFePO₄ (which may also be simply referred to as LFP)), a composite of lithium iron phosphate and carbon, lithium manganese phosphate (e.g., LiMnPO₄), a composite material of lithium manganese phosphate and carbon, lithium ferro-manganese phosphate, and a composite material of lithium ferro-manganese phosphate and carbon.

### [Electrolyte]

The electrolyte functions to conduct ions between the positive electrode tab and the negative electrode tab. In the present application, the kind of the electrolyte is not particularly limited, and may be selected according to a need. For example, the electrolyte may be in a liquid state, a gel state, or an all-solid state.

In some implementations, the electrolyte is a liquid and includes an electrolyte salt and a solvent.

In some implementations, the electrolyte salt is selected from sodium perchlorate, sodium hexafluorophosphate, sodium tetrafluoroborate, and sodium hexafluoroarsenate.

In some implementations, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, ethyl methyl sulfone, and diethyl sulfone.

In some implementations, the electrolyte optionally further includes an additive. As an example, the additive may include a negative electrode film-forming additive, a positive electrode film-forming additive, and may further include an additive capable of improving specific performance of the battery, for example, an additive improving overcharge performance of the battery, an additive improving high-temperature or low-temperature performance of the battery, and the like.

### [Separator]

In some implementations, a separator is further included in the secondary battery. The type of the separator is not particularly limited, and any known separator having a porous structure with good chemical stability and mechanical stability may be used.

In some implementations, the material of the separator may be at least one selected from the group consisting of glass fiber, nonwoven fabric, polyethylene, polypropylene, and polyvinylidene fluoride. The separator may be a single layer film or a multilayer composite film, and is not particularly limited. When the separator is a multilayer composite film, the materials of the respective layers may be the same or different and are not particularly limited.

In some implementations, the positive electrode tab, the negative electrode tab, and the separator may be manufactured into an electrode assembly through a winding process or a lamination process.

In some implementations, the secondary battery may include an outer package. The outer package may be used to package the electrode assembly and the electrolyte.

In some implementations, the outer package of the secondary battery may be a hard case, such as a hard plastic case, an aluminum case, a steel case, or the like. The outer package of the secondary battery may also be a pouch, such as a bag-type pouch. The material of the pouch may be plastic, and examples of the plastic include polypropylene, polybutylene terephthalate, and polybutylene succinate.

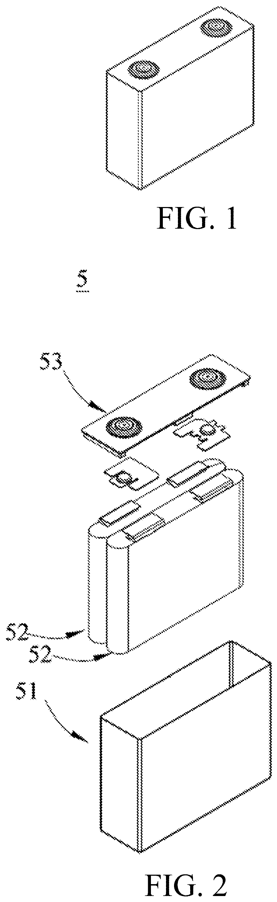

The shape of the secondary battery is not particularly limited in the present application, and may be cylindrical, square, or any other shape. For example, FIG. 1 shows a secondary battery 5 of a square structure as an example.

In some implementations, referring to FIG. 2, the outer package may include a housing 51 and a cover 53. The housing 51 may include a bottom plate and a side plate connected to the bottom plate, and the bottom plate and the side plate may define an accommodation chamber. The housing 51 has an opening communicating with the accommodation chamber, and the cover 53 can be provided on the opening to close the accommodation chamber. The positive electrode tab, the negative electrode tab, and the separator may be formed into the electrode assembly 52 through a winding process or a lamination process. The electrode assembly 52 is enclosed within the accommodation chamber. The electrolyte is impregnated in the electrode assembly 52. There may be one or a plurality of electrode assemblies 52 included in the secondary battery 5, and the number may be selected by those skilled in the art according to specific practical requirements.

In some implementations, the secondary batteries may be assembled into a battery module, and there may be one or a plurality of secondary batteries included in the battery module, and the specific number may be selected by those skilled in the art according to the application and capacity of the battery module.

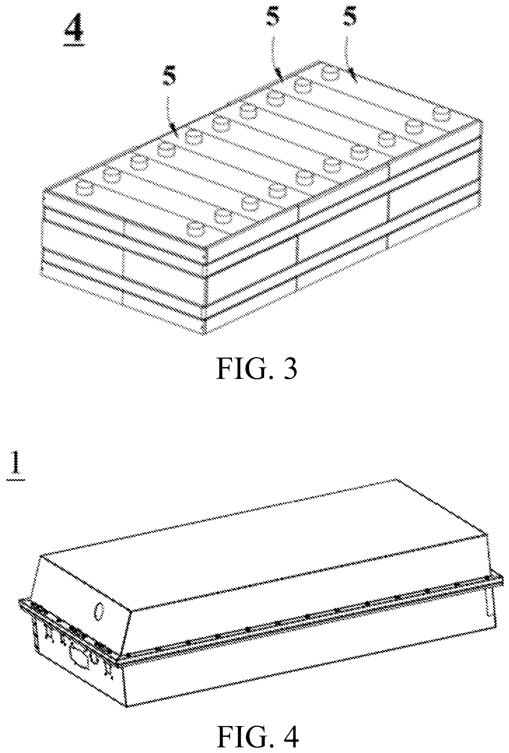

FIG. 3 shows a battery module 4 as an example. Referring to FIG. 3, in the battery module 4, a plurality of secondary batteries 5 may be arranged in series along the longitudinal direction of the battery module 4. Certainly, the batteries may be arranged in any other manner. Further, the plurality of secondary batteries 5 may be fixed by a fastener.

Alternatively, the battery module 4 may further include a housing having an accommodation space in which the plurality of secondary batteries 5 are accommodated.

In some implementations, the battery modules may be further assembled into a battery pack, and there may be one or a plurality of battery modules included in the battery pack, and the specific number may be selected by those skilled in the art according to the application and capacity of the battery pack.

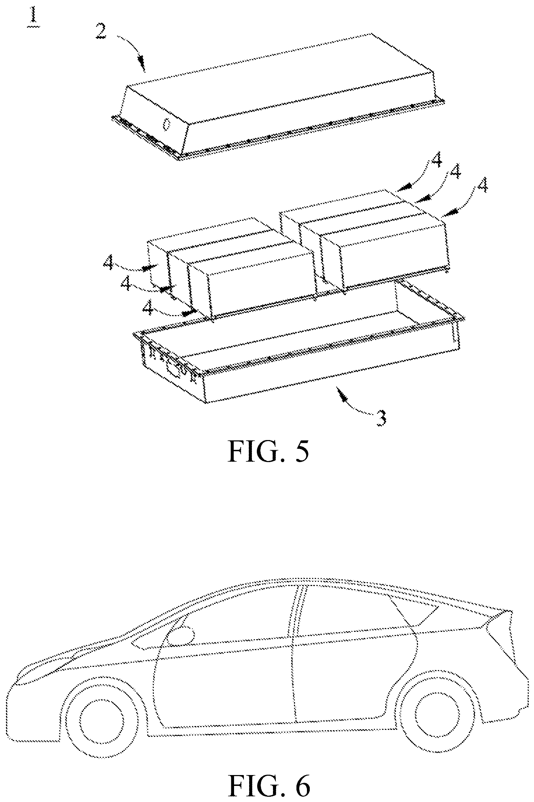

FIG. 4 and FIG. 5 show a battery pack 1 as an example. Referring to FIG. 4 and FIG. 5, a battery case and a plurality of battery modules 4 provided in the battery case may be included in the battery pack 1. The battery case includes an upper case 2 and a lower case 3, the upper case 2 being capable of covering the lower case 3 and forming a closed space for accommodating the battery modules 4. The plurality of battery modules 4 may be arranged in any manner in the battery case.

In addition, the present application further provides an electric device including at least one of a secondary battery, a battery module, or a battery pack provided by the present application. The secondary battery, the battery module, or the battery pack may be used as a power source of the electric device and may also be used as an energy storage unit of the electric device. The electric device may include a mobile device (e.g., a mobile phone, a notebook computer, etc.), an electric vehicle (e.g., a pure electric vehicle, a hybrid electric vehicle, a plug-in hybrid electric vehicle, an electric bicycle, an electric scooter, an electric golf cart, an electric truck, etc.), an electric train, a ship, a satellite, an energy storage system, and the like, but is not limited thereto.

The secondary battery, the battery module, or the battery pack may be selected according to use requirements of the electric device.

FIG. 6 shows an electric device as an example. The electric device is a pure electric vehicle, a hybrid electric vehicle, a plug-in hybrid electric vehicle, or the like. In order to meet the demand for high power and high energy density of the secondary battery by the electric device, a battery pack or a battery module may be used.

Embodiments of the present application are described below. The embodiments described below are illustrative only and are not to be construed as limiting the present application. In the embodiments, specific techniques or conditions are not indicated, and they are performed according to techniques or conditions described in documents in the art or according to the specification of the product. The reagents and instruments used without indicating the manufacturer are all conventional products that can be purchased commercially.

### 1. Method for Preparing Silicon-Based Negative Electrode Active Material

### 1.1 Overview

In the following detailed implementation, the method for preparing the silicon-based negative electrode active material is summarized as follows:
(1) providing a vapor containing Si element, O element, K element, P element and Mg element, and cooling the vapor to obtain a deposit;
(2) pulverizing the deposit to obtain a pulverized product;
(3) performing coating treatment on the pulverized product to obtain a product having a coating layer.

### 1.2 Detailed Description

In the following specific implementations, the method for preparing the silicon-based negative electrode active material is described in detail as follows:
(1) providing a raw material composition including elemental silicon, silicon oxide, a potassium source (K₂CO₃), a phosphorus source (P₂O₅), and a Mg source (metallic magnesium) according to the contents of Si element, O element, K element, P element, and Mg element in a target product;
(2) heating the raw material composition to 1300°C by vapor deposition in a helium atmosphere at an absolute pressure of 30 Pa to form a vapor, and cooling the vapor to 900°C to form a deposit;
(3) collecting the deposit and pulverizing it into powder;
(4) placing the powder in a reaction chamber of a vapor deposition apparatus, introducing a mixed gas of carbon source gas (acetylene) and nitrogen gas into the reaction chamber, acetylene being contained in an amount of 20 vol%, and heating to 750°C and keeping at this temperature for 2 hours to obtain a carbon-coated product;
(5) mixing the carbon-coated product with a lithium source (lithium amide) at 100:30 (mass ratio), heating to 650°C and keeping at the temperature for 2h, performing a lithiation reaction, and collecting the product to obtain the negative electrode active material.

In the above preparation method, the silicon-based negative electrode active materials having various K contents and P contents can be obtained by adaptively adjusting the contents of the alkaline earth metal source, the potassium source and the phosphorus source in the raw material mixture according to the composition of the target product. It should be understood that the contents of the potassium source and the phosphorus source in the raw material mixture should be adaptively adjusted depending on the component composition of the target product of the sample, when some of the elemental silicon and the silicon dioxide contain a specific amount of K element and P element in advance due to the purity of the elemental silicon and the silicon dioxide.

According to the method described above, a plurality of silicon-based negative electrode active material samples (hereinafter referred to as samples) having different K contents and P contents are prepared and obtained. These samples have the following properties:
(1) The silicon-based negative electrode active material is a silicon-based negative electrode active material having a carbon coating layer, where the content of the carbon coating layer is 4.2 ± 1%, and the remainder is the silicon-based negative electrode active material.
(2) The molar ratio of O element to Si element of the silicon-based negative electrode active material is 1 ± 0.1:1.
(3) The content of Mg element is 7 ± 0.5% based on 100% of the silicon-based negative electrode active material.
(4) The content of K based on 100% of the silicon-based negative electrode active material is shown in Table 1.
(5) The content of P based on 100% of the silicon-based negative electrode active material is shown in Table 1.
(6) The silicon-based negative electrode active material has a volume average particle diameter Dv50 of 6.0 ± 1 µm.
(7) The silicon-based negative electrode active material has a specific surface area of 5 ± 0.25 m²/g.
(8) The silicon-based negative electrode active material has a powder volume resistivity of 4.2 ± 0.25 Ω·cm at a pressure of 4 MPa.
(9) The silicon-based negative electrode active material has compacted density of 1.6 ± 0.1 g/cm³ at a pressure of 49000 N.
(10) The silicon-based negative electrode active material contains MgSiO₃, and the full width at half maximum of an XRD diffraction peak of MgSiO₃ is 0.5° ± 0.1° and a grain size thereof is 16 ± 1 nm.

Table 1 shows silicon-based negative electrode active material samples with different K and P contents.

### Preparation of Coin Cell

(1) Preparation of a negative electrode tab: sufficiently stirring and mixing the silicon-based negative electrode active material prepared above, conductive agent Super-P (conductive carbon black), and a binder PAA (polyacrylic acid) in an appropriate amount of deionized water at a mass ratio of 85:5:10 to form a uniform negative electrode slurry, coating the negative electrode slurry on the surface of copper foil as a negative electrode current collector, and performing drying and cold-pressing, to obtain a negative electrode tab.
(2) Counter electrode: metallic lithium sheet.
(3) Separator: polyethylene (PE) film.
(4) Preparation of an electrolyte: mixing ethylene carbonate (EC), ethyl methyl carbonate (EMC), and diethyl carbonate (DEC) at a volume ratio of 1:1:1 and then uniformly dissolving LiPF₆ in the above solution, and adding fluoroethylene carbonate (FEC) in which the concentration of LiPF₆ is 1mol/L and the mass ratio of FEC in the electrolyte is 6%.
(5) Preparation of a coin cell: stacking the negative electrode tab, the separator, and the metallic lithium sheet counter electrode in order, and adding the electrolyte to obtain the coin cell.

### 2. Analytical Detection Method

### 2.1 Elemental Analysis (for example, K, P, Si, and alkaline earth metal elements)

The content of an element is a well-known meaning in the art and can be measured using methods known in the art. The silicon-based negative electrode active material may be digested with reference to EPA-3052-1996 "Microwave Acid Digestion Method of Silicate", and then the content of the target element may be measured by inductively coupled plasma emission spectroscopy (ICP-OES), model ICAP 7000 of Thermo Fisher Scientific, according to EPA 6010D-2014 "Inductively Coupled Plasma Atomic Emission Spectroscopy". The specific testing method is as follows: 0.5g of a silicon-based negative electrode active material sample is subjected to microwave digestion with 10 mL of nitric acid and 10 mL of hydrofluoric acid, and after the digestion, the sample is placed in a 50 mL volumetric flask to obtain a constant volume, and then the content of the target element is measured by ICP-OES model ICAP-7000.

### 2.2 Elemental Analysis (Oxygen Element, Carbon Element)

The content of an element is a well-known meaning in the art and can be measured using methods known in the art. The content of the carbon element in the silicon-based negative electrode active material may be measured with reference to GB/T 20123-2006/ISO 15350:2000, and the measuring instrument may be an infrared carbon sulfur analyzer model HCS-140.

The oxygen content may refer to the JY/T 017-1996 elemental analyzer method, and a rapid OXY cube oxygen analyzer manufactured by Elementar may be used as a measuring instrument.

### 2.3 Volume Resistivity

The volume resistivity of a material is a well-known meaning in the art and can be measured using instruments and methods known in the art. For example, the powder volume resistivity of the silicon-based negative electrode active material of the present application at a pressure of 4 MPa may be measured by a four-probe method. The test method includes: adding the silicon-based negative electrode active material powder of the present application to a sample table, applying a pressure of 4 MPa to the powder by a press machine, and after the pressure stabilizes, reading the powder volume resistivity of the silicon-based negative electrode active material under the pressure of 4 MPa by a resistivity meter.

### 2.4 Compacted Density

The compacted density of a material is a well-known meaning in the art and can be determined using instruments and methods known in the art, for example, using an electronic pressure testing machine, such as the UTM7305 model, with reference to the GB/T24533-2009 standard. About 1 g of the sample is accurately weighed and placed in a mold having a bottom area of 1.327 cm², a pressure of 49000 N is applied to the sample using a pressure device, the pressure is maintained for 30 seconds, then the pressure is released, and then the height of the sample is measured to obtain the compacted density of the material by the formula ρ = m/(1.327 × h). Where ρ represents the compacted density of the material, m represents the mass of the sample, and h represents the height of the sample after application of the pressure of 49000 N and keeping at this pressure for 30 seconds and then release of the pressure.

### 2.4 Powder Particle Diameter Analysis

Dv10, Dv50, Dv90 of a material are well known in the art and can be tested using methods known in the art. It can be determined, for example, with reference to the standard GB/T 19077-2016, using a laser particle size analyzer (e.g. Malvern Master Size 3000).

The physical definitions of Dv10, Dv50, Dv90 are as follows: the particle diameters corresponding to the cumulative volume distribution percentages of silicon-based negative electrode active materials reaching 10%, 50%, and 90%, respectively.

### 2.5 Specific Surface Area Analysis

The specific surface area of a material is a well-known meaning in the art and can be determined by instruments and methods well known in the art, for example, by reference to GB/T 19587-2017 Gas Adsorption BET Specific Surface Area Standard for Solid Materials, using the nitrogen adsorption specific surface area analytical test method, and calculated by a Brunauer Emmett Teller (BET) method, where the nitrogen adsorption specific surface area analytical test can be performed by a Tri Star II 3020 specific surface and pore analyzer from Micromeritics, USA.

### 2.6 Battery Performance Test

### (1) Cycle performance

In a normal-pressure environment at 25°C, the coin cell is discharged at a constant current rate of 0.1C to 0.005 V, further discharged at a constant current rate of 0.04C to 0.005 V, and then allowed to stand for 5 minutes, and the discharge capacitance at this time is recorded as the first cycle lithium intercalation capacitance; and the coin cell is charged at a constant current rate of 0.1C to 1.5 V and then allowed to stand for 5 minutes. This is one cycle of charging and discharging. The charge capacitance at this time is recorded as the first cycle lithium deintercalation capacitance. The coin cell was subjected to a 30-cycle charge-discharge test according to the method described above, and the capacity for each delithiation is recorded. Cycle capacity retention rate (%) = first lap reversible delithiation capacity/500 cycle reversible delithiation capacity × 100%

### (2) 4C Discharge rate test

The coin cell is discharged at a constant current rate of 0.1C to 0.005 V, then discharged at a constant current rate of 0.04C to 0.005 V, then left to stand for 5 min, then charged at a constant current rate of 0.1C to 1.5 V, and left to stand for 5 min in a normal-pressure environment at 25°C, which is one cycle of charge-discharge process.

The charge/discharge current is changed by the same procedure to charge/discharge with a current of 0.1C, 0.33C, 1C, 2C, 4C, respectively, 10 cycles per current and the discharge capacity is recorded. 4C discharge capacity retention rate (%) = average 4C delithiation capacity/average 0.1C delithiation capacity × 100%

**Table 1**

| | Raw material | | | | | Silicon-based negative electrode active material | | | Battery performance | |
|---|---|---|---|---|---|---|---|---|---|---|
| | Elemental silicon /g | SiO₂ /g | K₂CO₃ /g | P₂O₅ /g | Metal magnesium /g | K content /ppm | P content /ppm | K/P Weight ratio | Capacity retention rate (%) | 4C discharge capacity retention rate (%) |
| E1 | 30.00 | 60.00 | 4.8 | 0.07 | 8 | 1180 | 80 | 14.8 | 73.8% | 55.4% |
| E2 | 30.00 | 60.00 | 5 | 0.1 | 8 | 1249 | 90 | 13.9 | 74.6% | 57.0% |
| E3 | 30.00 | 60.00 | 4 | 0.12 | 8 | 1100 | 95 | 11.6 | 73.5% | 53.7% |
| E4 | 30.00 | 60.00 | 5.6 | 0.13 | 8 | 1300 | 105 | 12.4 | 74.9% | 60.9% |
| E5 | 30.00 | 60.00 | 5.8 | 0.14 | 8 | 1320 | 116 | 11.4 | 76.3% | 62.8% |
| E6 | 30.00 | 60.00 | 6 | 0.15 | 8 | 1334 | 122 | 10.9 | 76.4% | 50.5% |
| E7 | 30.00 | 60.00 | 6.2 | 0.16 | 8 | 1352 | 127 | 10.6 | 76.7% | 58.5% |
| E8 | 30.00 | 60.00 | 6.4 | 0.17 | 8 | 1372 | 130 | 10.6 | 77.3% | 53.0% |
| E9 | 30.00 | 60.00 | 6.6 | 0.18 | 8 | 1390 | 135 | 10.3 | 77.4% | 64.5% |
| E10 | 30.00 | 60.00 | 6.8 | 0.19 | 8 | 1401 | 150 | 9.3 | 77.6% | 67.4% |
| E11 | 30.00 | 60.00 | 7 | 0.2 | 8 | 1431 | 156 | 9.2 | 77.8% | 67.0% |
| E12 | 30.00 | 60.00 | 7.2 | 0.21 | 8 | 1460 | 164 | 8.9 | 78.2% | 50.4% |
| E13 | 30.00 | 60.00 | 7.4 | 0.25 | 8 | 1472 | 191 | 7.7 | 78.5% | 67.1% |
| E14 | 30.00 | 60.00 | 3 | 1 | 8 | 800 | 1000 | 0.8 | 78.6% | 48.8% |
| D1 | 30.00 | 60.00 | 5 | None | 8 | 1249 | 0 | - | 74.3% | 46.1% |
| D2 | 30.00 | 60.00 | None | 0.1 | 8 | 0 | 90 | - | 65.4% | 45.5% |
| D3 | 30.00 | 60.00 | None | None | 8 | 0 | 0 | - | 63.2% | 41.1% |

### 3. Results and Discussion

Table 1 shows components and compositions of raw materials of silicon-based negative electrode active materials, contents and weight ratios of K element and P element in the silicon-based negative electrode active material product, and battery performance based on the above silicon-based negative electrode active material as the silicon-based negative electrode active material according to some embodiments of the present application. They are discussed separately below:

### (1) Composition of raw materials

The samples (E1 to E14) uses raw material elemental silicon of metal silicon 1 (Si ≧ 99 wt%, K = 100 ppm, P = 30 ppm).

The sample (D1 to D3) uses raw material elemental silicon of metal silicon 2 (Si ≧ 99.9 wt%, K and P are not contained).

From Table 2, it can be seen that K element and P element in the silicon-based negative electrode active material may come from various sources:
(a) K element in the silicon-based negative electrode active material may be derived from a raw material metal silicon;
(b) P element in the silicon-based negative electrode active material may be derived from a raw material metal silicon;
(c) K element in the silicon-based negative electrode active material may be derived from an additionally added potassium source;
(d) P element in the silicon-based negative electrode active material may be derived from an additionally added phosphorus source.

Those skilled in the art can adaptively adjust the contents of P element and K element in the raw materials according to the target chemical composition of the silicon-based negative electrode active material, and finally obtain the negative electrode active material having the target chemical composition. If it is necessary to increase/decrease the content of K element in the target negative electrode active material, metallic silicon (or silicon oxide) having a higher/lower K element content may be used, or the amount of the potassium source additionally added to the raw material may be increased/decreased. If it is necessary to increase/decrease the content of P element in the target negative electrode active material, metallic silicon (or silicon oxide) having a higher/lower P element content may be used, or the amount of phosphorus source additionally added to the raw material may be increased/decreased.

### (2) Synergistic effect of K element and P element

Referring to Embodiment E2 and Comparative Embodiments D1, D2 and D3, the silicon oxide-based composite of Comparative Embodiment D3 contains no K element and no P element and has a 4C capacity retention rate of 41.0%. The silicon oxide-based composite of Comparative Embodiment D1, which contains 1200 ppm of K element but no P element, has a 4C capacity retention value of 46.1%, which is increased by only 12% compared with D3. The silicon oxide-based composite of Comparative Embodiment D2, which contains 90 ppm of P element but no K element, has a 4C capacity retention value of 45.5%, which is increased by only 11% compared with D3. The silicon oxide-based composite of Embodiment E2 contains 1249 ppm of K element and 90 ppm of P element at the same time, the 4C capacity retention value is 57%, which is increased by 39% compared with D3, and the increase is far greater than the simple sum of the performance improvement brought by adding K or P alone (i.e. 12% + 11%= 33%). Thus, the above experimental evidence confirms the unexpected synergy that the combination of K and P does bring about.

### (3) Weight ratio of K/P in silicon oxide-based composite

The experimental data of Table 1 also confirms that when the weight ratio of K/P is greater than 1, the performance of the negative electrode active material is significantly improved.

The weight ratio of K/P in Embodiment E14 is 0.8:1 (<1), the 4C capacity retention value of the negative electrode active material is 48.8%, and the cycle performance is 78.6%. The weight ratio of K/P in Embodiments E1 to E13 is 7.7:1 to 14.8:1 (greater than 1), the 4C capacity retention value of the negative electrode active material is 50% to 67%, and the capacity retention value is 73% to 78%, which is superior to Embodiment E14.

The above experimental data indicates that the silicon oxide-based composite exhibits more significant cycle performance and rate performance improvement when the K content is greater than the P content.

### (4) K/P ratio in silicon oxide-based composite

As shown in Embodiments E4 to E13, when the weight ratio of K/P is 7.7:1 to 14.8:1, the 4C capacity retention value of the negative electrode active material is 50% to 67%, showing further improved cycle performance and rate performance.

As shown in Embodiments E9 to E11, when the weight ratio of K/P is 9.2:1 to 10.3:1, the 4C capacity retention value of the negative electrode active material is 64.5% to 67.4%, showing further improved cycle performance and rate performance.

### (5) Content of K element and content of P element in silicon oxide-based composite

As shown in Embodiments E1 to E14, when the content of K element in the silicon oxide-based composite is 600 ppm or more, for example, in the range of 800 ppm to 1500 ppm, the negative electrode active material exhibits improved cycle performance and rate performance.

As shown in Embodiments E1 to E14, the content of P element in the silicon oxide-based composite is 1000 ppm or less, for example, 50 ppm to 1000 ppm. The negative electrode active material exhibits improved cycle performance and rate performance.

As shown in Embodiments E1 to E13, the content of K element in the silicon oxide-based composite is 1000 ppm or more, for example, 1000 ppm to 1500 ppm, the negative electrode active material exhibits improved cycle performance and rate performance.

As shown in Embodiments E1 to E13, the content of P element in the silicon oxide-based composite is 500 ppm or less, for example, 50 ppm to 200 ppm. The negative electrode active material exhibits improved cycle performance and rate performance.

The above experimental data indicates that, when P element or K element is contained alone in the silicon oxide-based composite, the cycle performance and the rate performance are generally improved only in one direction, and the improvement is not significant. When the silicon oxide-based composite contains a combination of K element and P element, the negative electrode active material exhibits double improvement in cycle performance and rate performance, and the magnitude of the improvement is particularly significant, which indicates that K element and P element have an unexpected synergistic effect.

It should be noted that the present application is not limited to the above-described implementation. The above-described implementation is merely an example, and any implementation having substantially the same configuration as the technical concept and exhibiting the same operation and effect within the scope of the claims of the present application is included in the technical scope of the present application. In addition, various modifications that can be conceived by those skilled in the art may be made to the implementations without departing from the subject matter of the present application, and other implementations constructed by combining some of the constituent elements in the implementations are also included in the scope of the present application.

## Claims

1. A silicon-based negative electrode active material, comprising silicate containing alkaline earth metal elements, wherein the silicon-based negative electrode active material contains both K element and P element.

2. The silicon-based negative electrode active material according to claim 1, wherein the content of K element is greater than the content of P element.

3. The silicon-based negative electrode active material according to claim 1 or 2, wherein the mass ratio of K element to P element is greater than or equal to 7:1, and is optionally 9:1 to 15:1.

4. The silicon-based negative electrode active material according to any one of claims 1 to 3, wherein the content of K element is 600 ppm or more, and is optionally 800 ppm to 1500 ppm.

5. The silicon-based negative electrode active material according to any one of claims 1 to 4, wherein the content of P element is 500 ppm or less, and is optionally 50 ppm to 200 ppm.

6. The silicon-based negative electrode active material according to any one of claims 1 to 5, having one or a plurality of the following features:
(1) the silicon-based negative electrode active material has a volume average particle diameter Dᵥ50 of 4 µm to 10 µm, which is optionally 5 µm to 8 µm;
(2) the silicon-based negative electrode active material has a specific surface area of 6 m²/g or less, which is optionally 2 m²/g to 5 m²/g;
(3) the silicon-based negative electrode active material has a powder volume resistivity of 6 Ω·cm or less, which is optionally 0.5 Ω·cm to 4.5 Ω·cm, at a pressure of 4 MPa;
(4) the silicon-based negative electrode active material has a compacted density of 1.4 g/cm³ to 1.8 g/cm³, which is optionally 1.5 g/cm³ to 1.7 g/cm³, at a pressure of 49000 N;
(5) the silicate containing alkaline earth metal elements comprises silicate containing magnesium, and the full width at half maximum of an XRD diffraction peak of the silicate containing magnesium is 0.65° or less, and is optionally 0.40° to 0.60°; and
(6) the silicate containing alkaline earth metal elements comprises silicate containing magnesium, and the silicate containing magnesium has a grain size of 12 nm or more, which is optionally 13 nm to 20 nm.

7. The silicon-based negative electrode active material according to any one of claims 1 to 6, wherein at least a portion of a surface of the silicon-based negative electrode active material has a coating layer.

8. A method for preparing the silicon-based negative electrode active material according to any one of claims 1 to 7, comprising:
• providing raw materials containing Si element, O element, K element, P element, and alkaline earth metal element;
• using a vapor deposition method to heat the raw materials to form vapor and then cool the vapor to form a deposit; and
• pulverizing the deposit to obtain a pulverized product.

9. The method according to claim 8, further comprising:
performing coating treatment on the pulverized product to obtain a product having a coating layer.

10. The method according to claim 8 or 9, having one or a plurality of the following features:
(1) in the operation of heating the raw materials to form vapor, the heating temperature is 1100°C to 1550°C; and
(2) in the operation of cooling the vapor to form a deposit, the cooling temperature is 700°C to 900°C.

11. A secondary battery, comprising a negative electrode, wherein the negative electrode comprises the silicon-based negative electrode active material according to any one of claims 1 to 7.

12. An electric device, comprising the secondary battery according to claim 11.
